# EUROPEAN PATENT APPLICATION

(11) **EP 4 647 989 A1**
(43) Date of publication of application: **12.11.2025**
(21) Application number: 24814920.5
(22) Date of filing: 11.03.2024
(51) Int. Cl.: G06Q 10/30, H01M 10/42, H01M 10/48

(54) **REUSED SECONDARY BATTERY MANAGEMENT METHOD AND REUSED SECONDARY BATTERY MANAGEMENT SYSTEM**

(30) Priority: 30.05.2023 JP 2023088361
(71) Applicant: Toyo System Co., Ltd., Iwaki-shi, Fukushima 972-8316 (JP)
(72) Inventor: HASEGAWA Takamasa, Iwaki-shi, Fukushima 972-8316 (JP); TANNO Satoshi, Iwaki-shi, Fukushima 972-8316 (JP); SHOJI Masahiro, Iwaki-shi, Fukushima 972-8316 (JP); SHOJI Hideki, Iwaki-shi, Fukushima 972-8316 (JP)
(74) Representative: Schön, Christoph
(86) International application number: PCT/JP2024/009347
(87) International publication number: WO 2024/247433

(57) **Abstract**

Provided are a reused secondary battery management method and a reused secondary battery management system capable of managing a reused secondary battery even when the reused secondary battery is a secondary battery produced by reusing cells that constitute a used secondary battery. In the secondary battery management method and the secondary battery management system, when the reused secondary battery is a secondary battery produced by reusing cells that constitute the used secondary battery, data for identifying a model of the used secondary battery before being reused is recorded in the reused secondary battery and/or an attached member attached to and used for the reused secondary battery during a period from the production of the reused secondary battery until the start of reuse of the reused secondary battery.

## Description

### Technical Field

The present invention relates to a method and a system for managing a reused secondary battery.

### Background Art

Conventionally, a product information management method has been known (see Patent Literature 1). According to the technique of Patent Literature 1, it is possible to acquire, from a product information management server, support information necessary for reuse of secondary batteries, which is generated based on information on battery modules manufactured by a plurality of secondary battery manufacturers, and to promote reuse of the battery modules.

### Citation List

### Patent Literature

Patent Literature 1: Japanese Patent Application Laid-Open No. 2021-189568

### Summary of Invention

### Technical Problem

When a used secondary battery is reused, it can be considered to take out a battery pack that constitutes the used secondary battery in order to reassemble the used secondary battery as a new secondary battery (that is, as a reused secondary battery), or to reassemble the used secondary battery as a new secondary battery in which modules or cells, obtained by further disassembling the battery pack, are combined.

In such a case, after a battery pack, modules, or cells are removed from the used secondary battery, it is difficult to know information on the original secondary battery.

In the system of Patent Literature 1, since it has not been considered to manage a secondary battery reassembled by removing the battery pack, the modules, or the cells from the used secondary battery, there is a problem that it is not possible to carry out work on such a secondary battery, such as product repair, maintenance, and the like, according to the original secondary battery.

Therefore, an object of the present invention is to provide a reused secondary battery management method and a reused secondary battery management system capable of managing a reused secondary battery even when the reused secondary battery is a secondary battery produced by reusing cells that constitute a used secondary battery.

### Solution to Problem

A reused secondary battery management method of the present invention is such that,
when a reused secondary battery is a secondary battery produced by reusing cells that constitute a used secondary battery,
data for identifying a model of the used secondary battery before being reused is recorded in the reused secondary battery and/or an attached member attached to and used for the reused secondary battery
during a period from the production of the reused secondary battery until start of reuse of the reused secondary battery.

Further, a reused secondary battery management system of the present invention includes
an information acquisition element and an information recording element, and
the system is such that
the information acquisition element acquires, from a used secondary battery, data for identifying a model of the used secondary battery, and
when a reused secondary battery is a secondary battery produced by reusing cells that constitute the used secondary battery,
the information recording element records the data for identifying the model of the used secondary battery before being reused, which is acquired by the information acquisition element, in the reused secondary battery and/or an attached member attached to and used for the reused secondary battery
during a period from the production of the reused secondary battery until start of reuse of the reused secondary battery.

According to the present invention, the data for identifying the model of the used secondary battery before being reused is recorded in the reused secondary battery itself and/or the attached member attached to and used for the reused secondary battery.

Therefore, an administrator of the reused secondary battery can recognize the model of the used secondary battery before being reused by referring to the data for identifying the model of the used secondary battery before being reused, which is recorded in the reused secondary battery itself and/or the attached member. If there is data for identifying the model, the secondary battery can be identified, and the source, configuration, and the like of the secondary battery can be grasped.

Further, since the data for identifying the model of the used secondary battery before being reused is recorded during the period from the production of the reused secondary battery until the start of reuse of the reused secondary battery, the data can be recorded reliably in the reused secondary battery itself and/or the attached member.

Thus, even when the reused secondary battery is a secondary battery produced by reusing the cells that constitute the used secondary battery, it is possible to identify the model of the original secondary battery and to manage the reused secondary battery according to the model.

Note that, if information on whether or not the reused secondary battery is a secondary battery reassembled by removing a battery pack, modules, or cells from a used secondary battery, for which information on how much the degradation state has progressed is known, is acquired, the reused secondary battery can be managed effectively.

Therefore, in the reused secondary battery management method of the present invention,
it is preferred that
a value of the degradation state of the used secondary battery before being reused and data on a date or date and time when the used secondary battery was in the degradation state be recorded in the reused secondary battery and/or the attached member
during the period from the production of the reused secondary battery until the start of reuse of the reused secondary battery.

Alternatively, in the reused secondary battery management system of the present invention,
it is preferred that
the information acquisition element should recognize the value of the degradation state of the used secondary battery before being reused and the data on the date or the date and time when the used secondary battery was in the degradation state, and
the information recording element should record the value of the degradation state of the used secondary battery before being reused and the data on the date or the date and time when the used secondary battery was in the degradation state in the reused secondary battery and/or the attached member
during the period from the production of the reused secondary battery until the start of reuse of the reused secondary battery.

According to the present invention, the value of the degradation state of the used secondary battery before being reused and the data on the date or the date and time when the used secondary battery was in the degradation state are recorded in the reused secondary battery itself and/or the attached member.

Therefore, by referring to the data recorded in the reused secondary battery itself and/or the attached member, the value of the degradation state of the used secondary battery (that is, the secondary battery as the source of providing the cells that constitute the reused secondary battery) and the data on the date or the date and time when the used secondary battery was in the degradation state can be obtained, and hence the reused secondary battery can be managed effectively according to the data.

Further, in the reused secondary battery management method of the present invention, it is preferred that the reused secondary battery management method be executed by a computer, wherein
the computer includes a storage element that stores data,
the computer recognizes the value of the degradation state of the used secondary battery before being reused and the data on the date or the date and time when the used secondary battery was in the degradation state,
the computer records data for identifying the reused secondary battery in the reused secondary battery and/or the attached member
during the period from the production of the reused secondary battery until the start of reuse of the reused secondary battery, and
the computer stores, in the storage element, the data for identifying the reused secondary battery, the value of the degradation state of the used secondary battery before being reused, and the data on the date or the date and time when the used secondary battery was in the degradation state in association with one another.

Alternatively, in the reused secondary battery management system of the present invention, it is preferred that the reused secondary battery management system should further include a storage element that stores data, and
the reused secondary battery management system be such that
the information acquisition element recognizes the value of the degradation state of the used secondary battery before being reused and the data on the date or the date and time when the used secondary battery was in the degradation state,
the information recording element records the data for identifying the reused secondary battery in the reused secondary battery and/or the attached member
during the period from the production of the reused secondary battery until the start of reuse of the reused secondary battery, and
the storage element stores the data for identifying the reused secondary battery, the value of the degradation state of the used secondary battery before being reused, and the data on the date or the date and time when the used secondary battery was in the degradation state in association with one another.

According to the present invention, the data for identifying the reused secondary battery is recorded in the reused secondary battery and/or the attached member, and the data for identifying the reused secondary battery, the value of the degradation state of the used secondary battery before being reused, and the data on the date or the date and time when the used secondary battery was in the degradation state are stored in the storage element in association with one another.

Therefore, by referring to the storage element based on the data for identifying the reused secondary battery, which is recorded in the reused secondary battery and/or the attached member, the value of the degradation state of the used secondary battery before being reused and the data on the date or the date and time when the used secondary battery was in the degradation state can be acquired.

Thus, the administrator of the reused secondary battery can effectively manage the reused secondary battery by referring to information on at what point in time in the past and how much the degradation state of the used secondary battery 10 (that is, the secondary battery as the source of providing the cells that constitute the reused secondary battery) has progressed while estimating an approximate degradation state of the reused secondary battery from the elapsed time from the time point.

Thus, according to the present invention, even when the reused secondary battery is a secondary battery produced by reusing the cells that constitute the used secondary battery, the reused secondary battery can be effectively managed in consideration of additional information such as the value of the degradation state of the used secondary battery before being reused and the data on the date or the date and time when the used secondary battery was in the degradation state, in addition to the information of the model of the original secondary battery.

Further, in the reused secondary battery management method of the present invention,
it is preferred that the data for identifying the model of the used secondary battery before being reused be recorded in the reused secondary battery and/or the attached member in a manner readable by a portable terminal.

According to the present invention having such a configuration, the data for identifying the model of the used secondary battery before being reused can be read easily and reliably from the reused secondary battery and/or the attached member via the portable terminal.

Thus, according to the present invention, even when the reused secondary battery is a secondary battery produced by reusing the cells that constitute the used secondary battery, the reused secondary battery can be managed easily and reliably in consideration of the model of the secondary battery as the source of providing the cells that constitute the reused secondary battery.

Alternatively, in the reused secondary battery management method of the present invention, it is preferred that
the data for identifying the reused secondary battery be recorded in the reused secondary battery and/or the attached member in a manner readable by the portable terminal, and
the value of the degradation state of the used secondary battery before being reused and the data on the date or the date and time when the used secondary battery was in the degradation state be made acquirable through the data for identifying the reused secondary battery.

According to the present invention having the configuration concerned, the value of the degradation state of the used secondary battery before being reused and the data on the date or the date and time when the used secondary battery was in the degradation state can be acquired easily and reliably via the portable terminal.

Therefore, according to the present invention, even when the reused secondary battery is a secondary battery produced by reusing the cells that constitute the used secondary battery, the reused secondary battery can be managed easily, reliably, and effectively in consideration of additional information as the value of the degradation state of the used secondary battery before being reused and the data on the date or the date and time when the used secondary battery was in the degradation state in addition to the information on the model of the original secondary battery.

### Brief Description of Drawings

FIG, 1 is a flowchart illustrating an example of a reused secondary battery management method of the present invention.
FIG. 2 is an image diagram illustrating the example of the reused secondary battery management method of the present invention.
FIG. 3 is an image diagram illustrating examples of the reused secondary battery management method of the present invention.
FIG. 4 is a flowchart illustrating a modified example of the reused secondary battery management method of the present invention.
FIG. 5 is a block diagram illustrating an example of a device configuration when implementing the modified example of the reused secondary battery management method of the present invention.
FIG. 6 is an image diagram illustrating modified examples of the reused secondary battery management method of the present invention.
FIG. 7 is a diagram illustrating an example of output contents of the reused secondary battery management method of the present invention.
FIG. 8 is a flowchart illustrating another modified example of the reused secondary battery management method of the present invention.
FIG. 9 is a table illustrating an example of data used for processing in the modified examples of the reused secondary battery management method of the present invention.

### Description of Embodiment

### <Overview of Processing>

An example of a reused secondary battery management method of the present invention will be described with reference to the drawings. The reused secondary battery management method of the present invention is a reused secondary battery management method when a reused secondary battery is a secondary battery produced by reusing cells that constitute a used secondary battery.

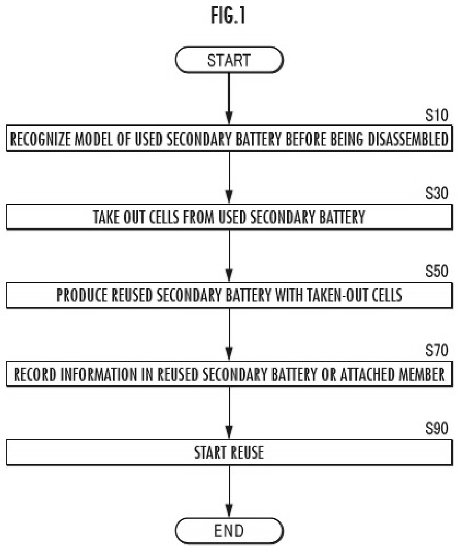

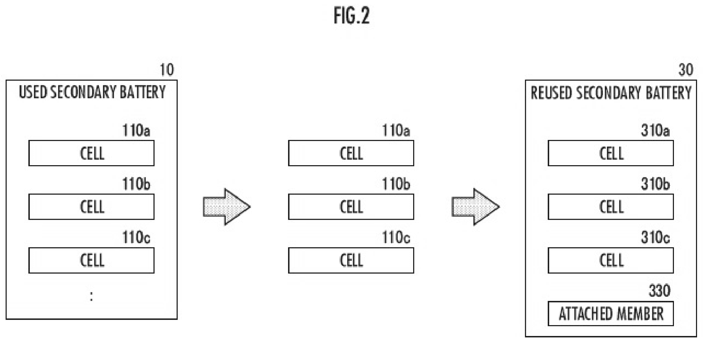

Therefore, as a premise of executing the reused secondary battery management method of the present invention, a model of a used secondary battery 10 before being disassembled is recognized (FIG. 1/S10), and cells 110 (110a, 110b, 110c, etc.) are taken out from the used secondary battery 10 (FIG. 1/S30; the left side and the center of FIG. 2) to produce a reused secondary battery with the taken-out cells 110 (FIG. 1/S50; the right side of FIG. 2).

In other words, the used secondary battery 10 for the reused secondary battery 30 is a secondary battery as a providing source of cells 310 that constitute the reused secondary battery 30. Therefore, the model of the used secondary battery 10 before being disassembled is, for example, a model number given by a manufacturer of the secondary battery to the secondary battery as the providing source of the cells 310 that constitute the reused secondary battery 30.

As a method of recognizing the model of the used secondary battery 10 before being disassembled, various methods may be adopted. In other words, for example, when a label or the like on which characters and/or symbols indicating the model are printed is pasted on the used secondary battery 10 before being disassembled, a worker recognizes the model of the used secondary battery 10 before being disassembled by reading the characters and symbols of the model printed on the label visually or by using a device that reads the characters and symbols of the model.

Alternatively, for example, a device that reads the characters and symbols of the model printed on the label may be incorporated in a disassembling line of the used secondary battery 10 so that the device will automatically recognize the model from the label pasted on the used secondary battery 10 before being disassembled.

The processing up to this point is processing in a stage prior to the implementation of the reused secondary battery management method of the present invention. The following is processing executed during a period from the production of the reused secondary battery 30 until the start of reuse of the reused secondary battery.

First, data for identifying the model of the used rechargeable battery 10 before being reused is recorded in the reused rechargeable battery 30 and/or an attached member 330 attached to and reused for the reused rechargeable battery 30 (FIG. 1/S70).

The data for identifying the model of the used rechargeable battery 10 before being reused, which is recorded in the reused rechargeable battery 30 itself and/or the attached member 330 attached to and used for the reused rechargeable battery 30, is the model of the used secondary battery 10 before being disassembled, which is recognized in FIG. 1/S10.

Further, as a method of recording the data for identifying the model of the used secondary battery 10 before being reused in the reused secondary battery 30 and/or the attached member 330 attached to and used for the reused secondary battery 30, various methods may be adopted as appropriate. In the following, when the attached member 330 is, for example, a sticker to stick on the reused secondary battery 30 will be described.

In this case, for example, the sticker on which the data for identifying the model of the used secondary battery 10 before being reused (for example, the model number of the used secondary battery 10; the same applies hereinafter) is printed is produced, and the produced sticker is stuck on the corresponding reused secondary battery 30 to record, in the reused secondary battery 30, the data for identifying the model of the used secondary battery 10 before being reused.

The task of sticking the sticker on the reused secondary battery 30 may be performed manually, or may be performed by a sticking device incorporated in a production line of the reused secondary battery 30.

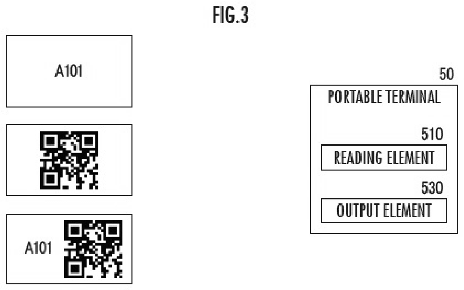

Further, as illustrated in FIG. 3, the data for identifying the model of the used secondary battery 10 before being reused may be such that the characters and symbols themselves are recorded in the reused secondary battery 30 itself and/or the attached member 330, or may be recorded by a portable terminal 50 including a corresponding reading element 510 converting the data into a readable image such as a barcode or a QR code (registered trademark) and printing the image.

FIG. 3 illustrates examples of print contents. The upper part of this figure illustrates a state in which only characters indicating the data for identifying the model of the used secondary battery 10 before being reused are printed. The central part of this figure illustrates a state in which only an image converted from the data for identifying the model of the used secondary battery 10 before reuse is printed. The lower part of this figure illustrates a state in which both the characters indicating the data and the image after being converted are printed.

The portable terminal 50 is a transportable device for reading data recorded in the reused secondary battery 30 or the attached member 330 and outputting the read result as necessary. The portable terminal 50 is a smartphone, a tablet terminal, a laptop personal computer, any other general-purpose computer, or a dedicated terminal produced for implementing the reused secondary battery management method of the present invention.

Then, it may be configured that the image after being converted as mentioned above is read through the reading element 510 of the portable terminal 50 and re-converted into the data for identifying the model of the used secondary battery 10 before being reused, and the re-conversion result is output to an output element 530 such as a display.

The reading element 510 is, for example, a camera and an OCR (Optical Character Reader) or a code reader such as for barcodes that reads the content in which the data for identifying the model of the used secondary battery 10 before being reused is printed on the reused secondary battery 30 and/or the attached member 330.

Note that, as a method of converting the data for identifying the model of the used secondary battery 10 before being reused into images of various codes, any of various conversion methods corresponding respectively to these codes may be used.

After that, reuse of the reused secondary battery 30 in which the data for identifying the model of the used secondary battery 10 before being reused is recorded is started (FIG. 1/S90).

Thus, in the reused secondary battery management method of the present invention, the data for identifying the model of the used secondary battery 10 before being reused is recorded in the reused secondary battery 30 and/or the attached member 330 attached to and used for the reused secondary battery 30 during the period from the production of the reused secondary battery 30 until the start of reuse of the reused secondary battery 30.

In the above, the embodiment in which the data for identifying the model of the used secondary battery 10 before being reused is printed on the attached member 330 is described, but the present invention is not limited thereto.

In other words, for example, the data for identifying the model of the used secondary battery 10 before being reused may be printed directly on the surface of the reused secondary battery 30, or may be recorded, for example, by engraving the data on the reused secondary battery 30 and/or the attached member 330.

Alternatively, for example, when the reused secondary battery 30 or the attached member 330 includes an electromagnetic recording medium, the data for identifying the model of the used secondary battery 10 before being reused may be electromagnetically recorded on the electromagnetic recording medium.

In this case, a data reading mechanism corresponding to the electromagnetic recording method may be selected appropriately for the reading element 510 of the portable terminal 50. In other words, for example, when the attached member 330 is an RF tag, the reading element 510 is an RFID reader.

### <Other Examples>

Other examples of the reused secondary battery management method of the present invention will be described below. Note that the description of processes that overlap with the process contents described above with reference to FIG. 1 is omitted.

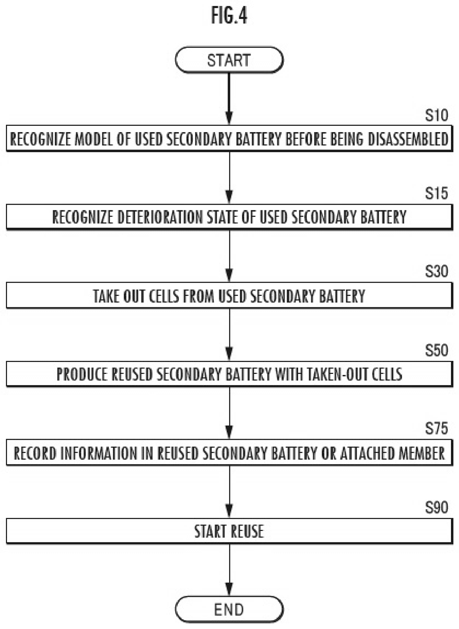

In a first modified example illustrated in FIG. 4, a value of the degradation state of the used secondary battery 10 before being reused and data on the date or the date and time when the used secondary battery 10 was in the degradation state are recorded in the reused secondary battery 30 and/or the attached member 330.

In this case, the model of the used secondary cell 10 before being disassembled is recognized (FIG. 4/S10), and the value of the degradation state of the used secondary cell 10 before being disassembled is recognized (FIG. 4/S15).

The value of the degradation state of the used secondary battery 10 is, for example, a ratio or an increase rate of an internal resistance value to the internal resistance value in the initial state of the used secondary battery 10, or a ratio (a so-called SOH) or a decrease rate of a discharge capacity to the discharge capacity in the initial state of the used secondary battery 10, but any other indicator of the degradation state may also be adopted as appropriate.

Further, as for a method of recognizing the value of the degradation state of the used secondary battery 10, any of various methods may be used. In other words, for example, any parameter (for example, a current value, a voltage value, a temperature, or the like) necessary for recognizing the degradation state of the used secondary battery 10 may be acquired from the used secondary battery 10 manually or automatically via a predetermined measurement device to recognize the used secondary battery 10 by appropriately using any algorithm capable of recognizing the degradation state of the used secondary battery 10 from the parameter.

Further, at this time, data on the date or the date and time when the used secondary battery 10 was in the degradation state is recognized together. The "data on the date or the date and time when the used secondary battery 10 was in the degradation state" is specifically the date or the date and time when the process of FIG. 4/S15 was performed.

As the data on the date or the date and time when the used secondary battery 10 was in the degradation state, a value input manually may be used, or a value acquired from a clock function included in an acquisition mechanism of the value of the degradation state of the used secondary battery 10 may be used.

After that, the value of the degradation state of the used secondary cell 10 before being reused, which is recognized in FIG. 4/S15, and the data on the date or the date and time when the used secondary cell 10 was in the degradation state are recorded in the reused secondary cell 30 or the attached member 330 produced by the cells 110 taken out from the used secondary cell 10 (FIG. 4/S75).

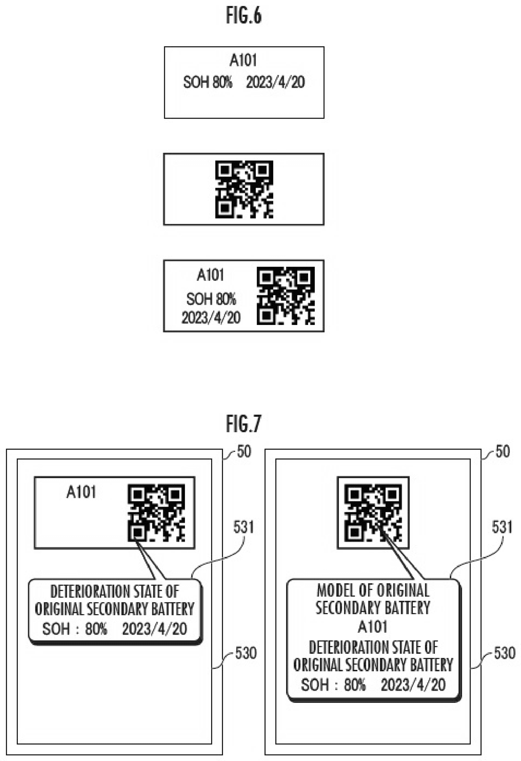

Like the data for identifying the model of the used secondary battery 10 before being reused, the value of the degradation state of the used secondary battery 10 before being reused and the data on the date or the date and time when the used secondary battery 10 was in the degradation state may also be recorded by printing a combination of characters and symbols as is, such as "2023/04/20" (the upper part of FIG. 6) or "2023/04/23 15:17" on the surface of the reused secondary battery 30 and/or the attached member 330. Alternatively, instead of or in addition to this, the value of the degradation state of the used secondary battery 10 before being reused and the data on the date or the date and time when the used secondary battery 10 was in the degradation state may be recorded by being converted into a code image as described above and printed (the central part or lower part of FIG. 6).

In this case, it may be configured that the image after being converted as mentioned above is read through the reading element 510 of the portable terminal 50 and re-converted into the value of the degradation state of the used secondary battery 10 before being reused and the data on the date or the date and time when the used secondary battery 10 was in the degradation state, and the re-conversion result is output to the output element 530 as illustrated in FIG. 7.

In an output example on the left side of FIG. 7, an image including the attached member 330, which is captured by a camera (not illustrated in FIG. 7 because the camera is located on the back of the portable terminal 50) that constitutes the reading element 510 of the portable terminal 50 according to an operation of an administrator, is displayed on the display as the output element 530. Further, the portable terminal 50 displays, on the display, a popup 531 for displaying, as the "degradation state of the original secondary battery," the value of the degradation state of the used secondary battery 10 before being reused and the data on the date or the date and time when the used secondary battery 10 was in the degradation state.

An output example on the right side is an output example in which only an image, obtained by converting the data for identifying the model of the used secondary battery 10 before being reused, the value of the degradation state of the used secondary battery 10 before being reused, and the data on the date or the date and time when the used secondary battery 10 was in the degradation state, is printed on the reused secondary battery 30 or the attached member 330.

In the output example, the portable terminal 50 displays, on the display, a popup 531 that displays the model number of the used secondary battery 10 as the "model of the original secondary battery" in addition to the "degradation state of the original secondary battery" described above.

By enabling such a display, for example, when performing inspection, maintenance, replacement, or the like of the reused secondary battery 30, the administrator of the reused secondary battery 30 can effectively manage the reused secondary battery 30 by referring to information on at what point in time in the past and how much the degradation state of the used secondary battery 10 (that is, the secondary battery as the providing source of the cells that constitute the reused secondary battery 30) has progressed, and the model of the used secondary battery 10 while estimating an approximate degradation state of the reused secondary battery 30 from the elapsed time from the time point.

After that, reuse of the reused secondary battery 30 is started (FIG. 4/S90).

In other words, in this modified example, during the period from the production of the reused secondary battery 30 until the start of reuse of the reused secondary battery 30, the data for identifying the model of the used secondary battery 10 before being reused, the value of the degradation state of the used secondary battery 10 before being reused, and the data on the date or the date and time when the used secondary battery 10 was in the degradation state are recorded in the reused secondary battery 30 and/or the attached member 330 attached to and used for the reused secondary battery 30.

Next, as a second modified example, a computer system that executes the reused secondary battery management method described with reference to FIG. 1 will be described.

The computer system is incorporated into a line of disassembling the used secondary battery 10 and a production line of the reused secondary battery 30 to execute the reused secondary battery management method of the present invention. In other words, the reused secondary battery management method of the present example is a reused secondary battery management method executed by a computer.

The computer system of the present embodiment has a server 70.

The server 70 is a computer including a storage element 710, an information processing element 730, an input element 750, an information acquisition element 770, and an information recording element 790.

The storage element 710 is configured, for example, by a storage device such as a ROM (Read Only Memory), a RAM (Random Access Memory), an HDD (Hard Disk Drive), or the like.

In the storage element 710, a result of processing by the reused secondary battery management method and information used for the processing are stored. In other words, for example, in the storage element 710, a secondary battery DB (database) 711 in which the data for identifying the reused secondary battery 30, the value of the degradation state of the used secondary battery 10 before being reused, and the data on the date or the date and time when the used secondary battery 10 was in the degradation state are associated with one another is stored as data as necessary. An example in which the secondary battery DB 711 is stored will be described later.

The information processing element 730 is a so-called processor composed of an arithmetic processing device such as a CPU (Central Processing Unit), a memory, I/O (Input/Output) devices, and the like.

The information processing element 730 reads and executes a predetermined program to execute processing necessary for implementing the reused secondary battery management method of the present example.

The input element 750 is, for example, a keyboard or a touch panel, a mouse, or any other pointing device that accepts input of data by an implementer of the reused secondary battery management method.

The information acquisition element 770 is a mechanism that acquires data for identifying the model of the used secondary battery 10 from a label pasted on the surface of the used secondary battery 10, which is, for example, a camera and an OCR or a code reader for barcodes.

Alternatively, for example, it may be configured that an image of the appearance of each of various secondary batteries and information on the model of the secondary battery are stored in the storage element 710 in association with each other so that the information processing element 730 acquires the model of the secondary battery corresponding to the appearance based on the image of the appearance of the used secondary battery 10 acquired through the camera as the information acquisition element 770.

The information acquisition element 770 and the server 70 are communicably connected to each other via a wired or wireless communication network.

The information recording element 790 records the data for identifying the model of the used secondary battery 10 before being reused in the reused secondary battery 30 itself and/or the attached member 330 attached to and used for the reused secondary battery 30.

When the attached member 330 is, for example, a sticker or the like to be stuck on the reused secondary battery 30, the information recording element 790 is a printing mechanism that prints, on the surface of the attached member 330, the data for identifying the model of the used secondary battery 10 before being reused itself and/or the data converted into an image such as a barcode or a QR code (registered trademark), or the like in a manner readable by the portable terminal 50.

Alternatively, for example, when the attached member 330 is an electromagnetic recording medium, the information recording element 790 is an information writing mechanism corresponding to the recording medium to electromagnetically record the data for identifying the model of the used secondary battery 10 before being reused on the recording medium in a manner readable by the portable terminal 50. In other words, for example, when the attached member 330 is an RF tag, the information recording element 790 is an RFID writer.

The information recording element 790 and the server 70 are communicably connected to each other via a wired or wireless communication network.

In the present modified example, the information acquisition element 770 incorporated in the line of disassembling the used secondary batteries 10 recognizes the model of the used secondary battery 10 before being disassembled from the used secondary battery 10 (FIG. 1/S10), and transmits the model to the server 70.

Then, in response to an instruction signal from the server 70, the information recording element 790 incorporated in the production line of the reused secondary battery 30 records the data for identifying the model of the used secondary battery 10 before being reused in the reused secondary battery 30, produced with the cells 110 taken out from the used secondary battery 10, or the attached member 330, (FIG. 1/S70).

Alternatively, in the case of the first modified example described above, it may further be modified that the information acquisition element 770 incorporated in the disassembling line of the used secondary battery 10 recognizes the degradation state of the used secondary battery 10 before being disassembled (FIG. 4/S15) and recognizes the time when the degradation state was recognized, and the information recording element 790 records, in the reused secondary battery 30 and/or the attached member 330, the value of the degradation state of the used secondary battery 10 and the data on the date or the date and time when the used secondary battery 10 was in the degradation state.

In this case, for example, the server 70, which has recognized the value of the degradation state of the used secondary battery 10 before being disassembled and the time when the value was recognized via the information acquisition element 770, records the data for identifying the model of the used secondary battery 10 before being reused, the value of the degradation state of the used secondary battery 10 before being reused, and the data on the date or the date and time when the used secondary battery 10 was in the degradation state in the reused secondary battery 30, produced with the cells 110 taken out from the used secondary battery 10, and/or the attached member 330 via the information recording component 790 (FIG. 4/S75).

As a method of causing the information recording element 790 to record these pieces of data in the reused secondary battery 30 or the attached member 330, any of the above-described various methods may be used.

After that, reuse of the reused secondary battery 30 is started (FIG. 1/S90, FIG. 4/S90).

Next, as a third modified example, an example in which the secondary battery DB 711 is stored in the storage element 710 as data in which the data for identifying the reused secondary battery 30, the value of the degradation state of the used secondary battery 10 before being reused, and the data on the date or the date and time when the used secondary battery 10 was in the degradation state are associated with one another will be described.

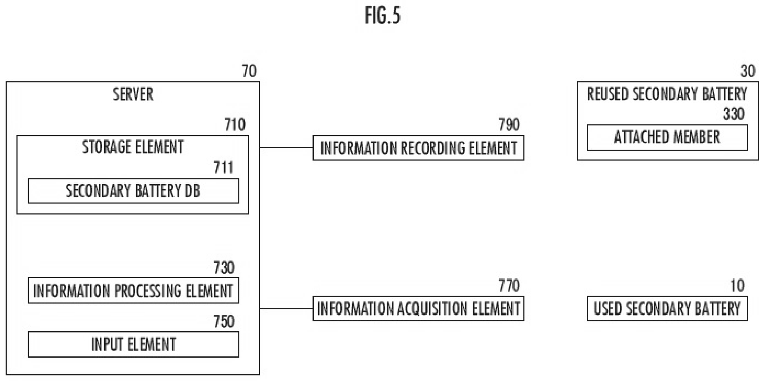

The reused secondary battery management method of this example is also the reused secondary battery management method executed by the computer. The device configuration of the reused secondary battery management system of the present example is the same as that of FIG. 5.

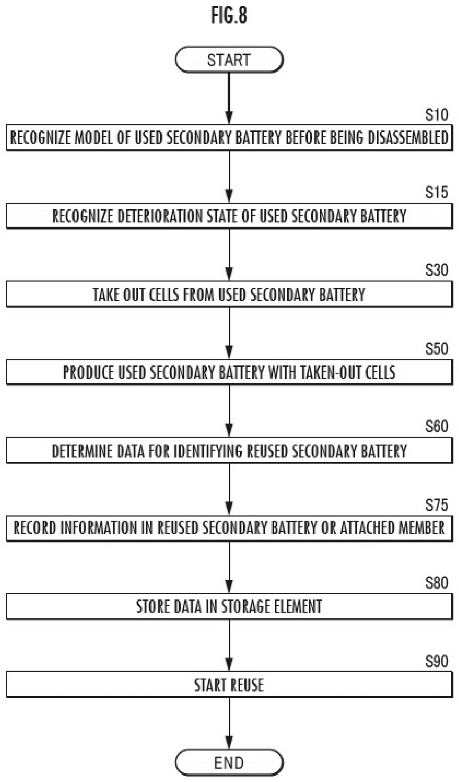

In the present example, the information processing element 730 recognizes, via the information acquisition element 770, the model of the used secondary battery 10 before being disassembled, the value of the degradation state of the used secondary battery 10 before being reused, and the data on the date or the date and time when the used secondary battery 10 was in the degradation state (FIG. 8/S10, S15).

Then, when the reused secondary battery 30 is produced with the cells 110 taken out from the used secondary battery 10 (FIG. 8/S50), the information processing element 730 determines data for identifying the reused secondary battery 30 (FIG. 8/S60).

In the present invention, the data for identifying the reused secondary battery 30 is an ID (reused secondary battery ID) for uniquely identifying the reused secondary battery 30, which is composed, for example, of a combination of letters, numbers, and symbols.

Then, the information processing element 730 records the determined data for identifying the reused secondary battery 30 in the reused secondary battery 30 and/or the attached member 330 via the information recording element 790 (FIG. 8/S75).

Note that the information recording element 790 records the data for identifying the reused secondary battery 30 in the reused secondary battery 30 and/or the attached member 330 in a manner readable by the portable terminal 50.

Further, the information processing element 730 stores, in the secondary battery DB 711, the data for identifying the reused rechargeable battery 30, the value of the degradation state of the used secondary battery 10 before being reused, and the data on the date or the date and time when the used secondary battery 10 was in the degradation state in association with one another.

The value of the degradation state of the used secondary battery 10 before being reused, and the data on the date or date and time when the used secondary battery was in the degradation state, which are stored at this time, are the value and data recognized in FIG. 8/S15.

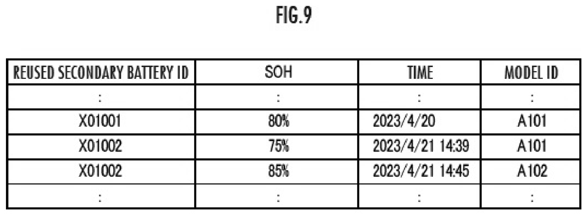

FIG. 9 illustrates an example of the secondary battery DB 711. In the secondary battery DB 711, reused secondary battery IDs that identify respective reused secondary batteries, SOH values as values of degradation states of respective used secondary batteries 10 before being reused, and time values as data on the dates or the dates and times when the respective used secondary batteries were in the degradation states are stored in association with one another. In addition, in the example illustrated in FIG. 9, model IDs as models of the respective used secondary batteries 10 before being reused are further associated and stored together.

Further, for example, by making the following processing executable, the value of the degradation state of the used secondary cell 10 before being reused, and the data on the date or the date and time when the used secondary cell 10 was in the degradation state, which are recorded in the secondary battery DB 711 of the storage element 710, can be acquired through the data for identifying the reused secondary battery 30 recorded in the reused secondary battery 30 or the attached member 330.

In other words, the portable terminal 50 and the server 70 are configured to be able to communicate with each other via a wireless or wired communication network. Then, the reading element 510 of the portable terminal 50 reads the data for identifying the reused secondary battery 30, recorded in the reused secondary battery 30 and/or the attached member 330, according to an operation by the administrator, and the portable terminal 50 transmits inquiry data to the server 70 based on the read data for identifying the reused secondary battery 30. The information processing element 730 of the server 70 that has received the inquiry data refers to the secondary battery DB 711 based on the data for identifying the reused secondary battery 30 included in the received data to acquire the value of the degradation state of the used secondary battery 10 before being reused and the data on the date or the date and time when the used secondary battery 10 was in the degradation state, which are associated with the received data, and to transmit the acquired value and data to the portable terminal 50.

By doing this, even when there is little space or capacity to record data in the reused secondary battery 30 and/or the attached member 330, the administrator can be caused to recognize abundant information, such as the value of the degradation state of the used secondary battery 10 before being reused and the data on the date or the date and time when the used secondary battery 10 was in the degradation state, through little information as the data for identifying the reused secondary battery 30 recorded in the reused secondary battery 30 and/or the attached member 330.

Further, as illustrated in FIG. 9, when the reused secondary battery ID as data for identifying each reused secondary battery 30 and the model ID as the model of each used secondary battery 10 before being reused are stored in the secondary battery DB 711 in association with each other, only the data for identifying the reused secondary battery 30 has to be stored in the reused secondary battery 30 and/or the attached member 330.

In other words, the model of the used secondary battery 10 before being reused can be acquired by referring to the secondary battery DB 711 through the data for identifying the used secondary battery 30. Therefore, in this case, the data for specifying the reused secondary battery 30 is to be recorded, as data for identifying the model of the used secondary battery 10 before being reused, in the reused secondary battery 30 and/or the attached member 330 attached to and used for the reused secondary battery 30.

Alternatively, for example, the information acquisition element 770 incorporated in a sorting line of a shipping system for reuse of the reused secondary battery 30 may be configured to acquire the data for identifying the reused secondary battery 30 recorded in the reused secondary battery 30 and/or the attached member 330, make an inquiry to the server 70 as described above based on the data concerned, and cause the shipping system to acquire, as a response to the inquiry, the value of the degradation state of the used secondary battery 10 before being reused and the data on the date or the date and time when the used secondary battery 10 was in the degradation state so that the shipping system determines a shipping destination of the reused secondary battery 30 according to the acquired data, and transmits, to the sorting line, a signal for controlling the sorting line.

After that, reuse of the reused secondary battery 30 is started (FIG. 8/S90).

Although the modified examples of the reused secondary battery management method of the present invention have been described above, the present invention is not limited to the examples, and various modifications may be made as appropriate without departing from the spirit of the present invention.

In other words, for example, the information recording element 790 may be provided in the portable terminal 50, and some or all of the processes executed by the information recording element 790 may be executed via the portable terminal 50.

### Description of Reference Numerals

10...used secondary battery, 30... reused secondary battery, 50...portable terminal, 330...attached member, 710...storage element.

## Claims

1. A reused secondary battery management method wherein,
when a reused secondary battery is a secondary battery produced by reusing cells that constitute a used secondary battery,
data for identifying a model of the used secondary battery before being reused is recorded in the reused secondary battery and/or an attached member attached to and used for the reused secondary battery
during a period from production of the reused secondary battery until start of reuse of the reused secondary battery.

2. The reused secondary battery management method according to Claim 1, wherein
a value of a degradation state of the used secondary battery before being reused and data on a date or date and time when the used secondary battery was in the degradation state are further recorded in the reused secondary battery and/or the attached member
during the period from the production of the reused secondary battery until the start of reuse of the reused secondary battery.

3. The reused secondary battery management method according to Claim 1, wherein
the reused secondary battery management method is executed by a computer,
the computer includes a storage element that stores data,
the computer recognizes the value of the degradation state of the used secondary battery before being reused and the data on the date or the date and time when the used secondary battery was in the degradation state,
the computer records data for identifying the reused secondary battery in the reused secondary battery and/or the attached member
during the period from the production of the reused secondary battery until the start of reuse of the reused secondary battery, and
the computer stores, in the storage element, the data for identifying the reused secondary battery, the value of the degradation state of the used secondary battery before being reused, and the data on the date or the date and time when the used secondary battery was in the degradation state in association with one another.

4. The reused secondary battery management method according to Claim 1, wherein
the data for identifying the model of the used secondary battery before being reused is recorded in the reused secondary battery and/or the attached member in a manner readable by a portable terminal.

5. The reused secondary battery management method according to Claim 3, wherein
the data for identifying the reused secondary battery is recorded in the reused secondary battery and/or the attached member in a manner readable by a portable terminal, and
the value of the degradation state of the used secondary battery before being reused and the data on the date or the date and time when the used secondary battery was in the degradation state, which are recorded in the storage element, are made acquirable through the data for identifying the reused secondary battery.

6. A reused secondary battery management system comprising
an information acquisition element and an information recording element,
wherein
the information acquisition element acquires, from a used secondary battery, data for identifying a model of the used secondary battery, and
when a reused secondary battery is a secondary battery produced by reusing cells that constitute the used secondary battery,
the information recording element records the data for identifying the model of the used secondary battery before being reused, which is acquired by the information acquisition element, in the reused secondary battery and/or an attached member attached to and used for the reused secondary battery
during a period from production of the reused secondary battery until start of reuse of the reused secondary battery.

7. The reused secondary battery management system according to Claim 6, wherein
the information acquisition element recognizes a value of a degradation state of the used secondary battery before being reused and data on a date or date and time when the used secondary battery was in the degradation state, and
the information recording element records the value of the degradation state of the used secondary battery before being reused and the data on the date or the date and time when the used secondary battery was in the degradation state in the reused secondary battery and/or the attached member
during the period from the production of the reused secondary battery until the start of reuse of the reused secondary battery.

8. The reused secondary battery management system according to Claim 6, further comprising
a storage element that stores data, wherein
the information acquisition element recognizes a value of a degradation state of the used secondary battery before being reused and data on a date or date and time when the used secondary battery was in the degradation state,
the information recording element records the data for identifying the reused secondary battery in the reused secondary battery and/or the attached member
during the period from the production of the reused secondary battery until the start of reuse of the reused secondary battery, and
the storage element stores the data for identifying the reused secondary battery, the value of the degradation state of the used secondary battery before being reused, and the data on the date or the date and time when the used secondary battery was in the degradation state in association with one another.
